# EUROPEAN PATENT APPLICATION

(11) **EP 4 415 060 A1**
(43) Date of publication of application: **14.08.2024**
(21) Application number: 24156778.3
(22) Date of filing: 09.02.2024
(51) Int. Cl.: H01L 31/068

(54) **BACK-CONTACT SOLAR CELL AND METHOD FOR PRODUCING BACK-CONTACT SOLAR CELL**

(30) Priority: 10.02.2023 CN 202310111624
(71) Applicant: Trina Solar Co., Ltd, Changzhou, Jiangsu 213031 (CN)
(72) Inventor: CHEN, Daming, Changzhou, 213031 (CN); ZHANG, Zhuohan, Changzhou, 213031 (CN); JI, Wenxian, Changzhou, 213031 (CN); HU, Yunyun, Changzhou, 213031 (CN); LIU, Wei, Changzhou, 213031 (CN); YANG, Rui, Changzhou, 213031 (CN); ZHANG, Xueling, Changzhou, 213031 (CN); YANG, Guangtao, Changzhou, 213031 (CN); CHEN, Yifeng, Changzhou, 213031 (CN)
(74) Representative: Nederlandsch Octrooibureau

(57) **Abstract**

A back-contact solar cell and a method for producing a back-contact solar cell are provided. The back-contact solar cell comprises a silicon substrate having a front surface and a back surface opposite to each other, and the silicon substrate is of a first doping type; and a first emitter, a first isolation region, a second isolation region, and a second emitter disposed on the back surface of the silicon substrate, wherein the first isolation region and the second isolation region are disposed between the first emitter and the second emitter in a first direction, the first emitter is of a second doping type, the first isolation region and the second emitter are of the first doping type, and the first direction intersects a thickness direction of the silicon substrate.

## Description

### Technical field

The present disclosure mainly relates to the field of photovoltaic technology and specifically relates to a back-contact solar cell and a method for producing a back-contact solar cell.

### Background

The electrodes of the interdigitated back-contact (IBC) solar cell are located on the back side of the solar cell, which reduces the occlusion of the light-receiving surface of the solar cell, thereby improving the conversion efficiency of the solar cell and gradually becoming the main research and development direction of industrialized high-efficiency solar cell. Currently, during the mass production of back-contact solar cells, there are problems such as excessive reverse leakage and failure of hot spot test.

Therefore, how to solve the problem of excessive reverse leakage and failure of hot spot tests in back-contact solar cells is an issue that needs to be solved urgently.

### Summary

The technical problem to be solved by this disclosure is to provide a back-contact solar cell and a method for producing a back-contact solar cell, both of which can solve the problem of excessive reverse leakage of the solar cell and failure to pass the hot spot test.

In order to achieve this purpose, the present disclosure proposes the following technical solutions: a back-contact solar cell comprising a silicon substrate having a front surface and a back surface opposite to each other, and the silicon substrate is of a first doping type; and a first emitter, a first isolation region, a second isolation region, and a second emitter disposed on the back surface of the silicon substrate, wherein the first isolation region and the second isolation region are disposed between the first emitter and the second emitter in a first direction, the first emitter is of a second doping type, the first isolation region and the second emitter are of the first doping type, and the first direction intersects a thickness direction of the silicon substrate.

In one embodiment, the first emitter, the first isolation region, the second isolation region, and the second emitter are successively disposed on the back surface of the silicon substrate in the first direction.

In one embodiment, the first isolation region has a first side and a second side opposite to each other in the first direction, and the second isolation region has a third side and a fourth side opposite to each other in the first direction, the first side connects to the first emitter, the second side connects to the third side, and the fourth side connects to the second emitter.

In one embodiment, the second isolation region is of the second doping type or the first doping type.

In one embodiment, a first portion of the second isolation region is of the first doping type, and a second portion of the second isolation region is of the second doping type.

In one embodiment, the first emitter includes a tunnel oxide layer and a polysilicon layer, the tunnel oxide layer is disposed on the back surface of the silicon substrate, and the polysilicon layer is disposed on a surface of the tunnel oxide layer away from the silicon substrate, and the polysilicon layer is of the second doping type.

In one embodiment, the first isolation region has a pyramidal texture.

In one embodiment, a surface of the second isolation region away from the silicon substrate in the thickness direction has a flat topography.

In one embodiment, the solar cell further comprises a first passivation layer and an anti-reflection layer, wherein the first passivation layer and the anti-reflection layer are successively disposed on the front surface of the silicon substrate in the thickness direction.

In one embodiment, the first passivation layer includes a chemical passivation layer and a field passivation layer, wherein the chemical passivation layer is disposed on the front surface of the silicon substrate, the field passivation layer is disposed on a surface of the chemical passivation layer away from the silicon substrate.

The present disclosure proposes a method for producing a back-contact solar cell, comprising: providing a silicon substrate having a front and a back surface opposite to each other and being of a first doping type; and forming a first emitter, a first isolation region, a second isolation region, and a second emitter on the back surface of the silicon substrate, wherein the first isolation region and the second isolation region are disposed between the first emitter and the second emitter in a first direction, the first emitter is of a second doping type, the first isolation region and the second emitter are of the first doping type, and the first direction intersects a thickness direction of the silicon substrate.

In one embodiment, the first emitter, the first isolation region, the second isolation region, and the second emitter are successively formed on the back surface of the silicon substrate.

In one embodiment, the first isolation region has a first side and a second side opposite to each other in the first direction, and the second isolation region has a third side and a fourth side opposite to each other in the first direction, the first side connects to the first emitter, the second side connects to the third side, and the fourth side connects to the second emitter.

In one embodiment, the first emitter includes a tunnel oxide layer and a polysilicon layer, the tunnel oxide layer is disposed on the back surface of the silicon substrate, and the polysilicon layer is disposed on a surface of the tunnel oxide layer away from the silicon substrate, wherein the polysilicon layer is of the second doping type.

In one embodiment, the first isolation region has a pyramidal texture, wherein a manner of forming the pyramid texture includes using an alkali solution to etch a surface of the first isolation region away from the silicon substrate.

In one embodiment, the second isolation region is of the second doping type or the first doping type.

In one embodiment, a first portion of the second isolation region is of the first doping type, and a second portion of the second isolation region is of the second doping type.

In one embodiment, a surface of the second isolation region away from the silicon substrate in the thickness direction has a flat topography.

In one embodiment, the method further comprises successively forming a first passivation layer and an anti-reflection layer on the front surface of the silicon substrate in the thickness direction.

The back-contact solar cell and the method of the present disclosure solve the problem of excessive reverse leakage of the solar cell and failure to pass the hot spot test by arranging the first isolation region and the second isolation region between the first emitter and the second emitter.

### Description of the drawings

In order to make the above purposes, features, and advantages of the present disclosure more obvious and understandable, the specific embodiments of the present disclosure are described in detail below with reference to the accompanying drawings, wherein:
FIG. 1 is a schematic cross-sectional view of a back-contact solar cell according to an embodiment of the present disclosure;
FIG. 2 is a partially enlarged schematic diagram of the rectangular dotted frame portion of the back-contact solar cell in FIG. 1;
FIG. 3 is an enlarged partial cross-sectional view of a back-contact solar cell according to an embodiment of the present disclosure;
FIG. 4 is an enlarged partial cross-sectional view of a back-contact solar cell according to another embodiment of the present disclosure;
FIG. 5 is an exemplary flow chart of a method for producing a back-contact solar cell according to an embodiment of the present disclosure.

### Reference signs

| | | | |
|---|---|---|---|
| silicon substrate | 110 | first isolation region | 150 |
| first passivation layer | 120 | second isolation region | 160 |
| anti-reflection layer | 130 | second emitter | 170 |
| first emitter | 140 | second passivation layer | 180 |
| tunnel oxide layer | 141 | first electrode | 190 |
| polysilicon layer | 142 | second electrode | 210 |

### Preferred Embodiment of the Present Invention

In order to make the above obj ects, features, and advantages of the present disclosure more obvious and understandable, the specific embodiments of the present disclosure are described in detail below with reference to the accompanying drawings.

Many specific details are set forth in the following description to fully understand the present disclosure, but the present disclosure can also be implemented in other ways different from those described here, so the present disclosure is not limited by the specific embodiments disclosed below.

As shown in this disclosure and claims, words such as "a", "an", "an" and/or "the" do not specifically refer to the singular and may include the plural unless the context clearly indicates an exception. Generally speaking, the terms "comprising" and "comprising" only imply the inclusion of clearly identified steps and elements, and these steps and elements do not constitute an exclusive list. The method or apparatus may also include other steps or elements.

In addition, it should be noted that the use of words such as "first" and "second" to define parts is only to facilitate the distinction between corresponding parts. Unless otherwise stated, the above words have no special meaning and therefore cannot be understood. To limit the scope of protection of this disclosure. In addition, although the terms used in this disclosure are selected from well-known and commonly used terms, some terms mentioned in the specification of this disclosure may be selected by the applicant based on his or her judgment, and their detailed meanings are set out herein, their detailed meanings stated in the relevant section of the description. Furthermore, the disclosure is required to be understood not merely by the actual terms used, but also by the meaning connoted by each term.

Flowcharts are used in this disclosure to illustrate operations performed by systems according to embodiments of this disclosure. It should be understood that the preceding or following operations are not necessarily performed in exact order. Instead, the various steps can be processed in reverse order or simultaneously. And, other operations may be added to these processes, or a step or steps may be removed from these processes.

The back-contact solar cell and the method for producing a back-contact solar cell of the present disclosure will be described through specific embodiments.

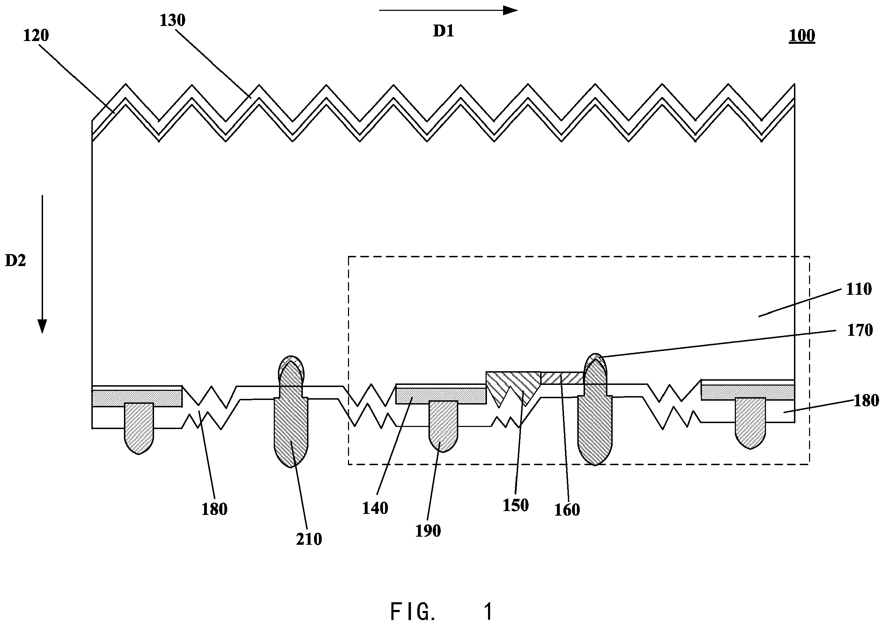

FIG. 1 is a schematic cross-sectional view of a back-contact solar cell according to an embodiment of the present disclosure. Referring to FIG. 1, the back-contact cell 100 includes a silicon substrate 110, a first passivation layer 120, an anti-reflection layer 130, a first emitter 140, a first isolation region 150, a second isolation region 160, and a second emitter 170.

Specifically, as shown in FIG. 1, the silicon substrate 110 has a front surface and a back surface opposite to each other in the thickness direction D2, where the "front surface" refers to a surface of the silicon substrate 110 that receives light when the solar cell is operating. The first passivation layer 120 is disposed on the front surface of the silicon substrate 110 in the thickness direction D2, and the anti-reflection layer 130 is disposed on a surface of the first passivation layer 120 away from the silicon substrate 110 in the thickness direction D2. The first passivation layer 120 can reduce carrier recombination on the front surface of the silicon substrate 110, thereby improving the efficiency of the solar cell. The anti-reflection layer 130 can reduce the reflection of incident light, thereby improving the absorption of incident light by the solar cell. In some embodiments, the first passivation layer 120 includes one or more of aluminum oxide, silicon oxide, and silicon oxynitride, and the anti-reflection layer 130 includes silicon nitride.

In one embodiment, the first passivation layer 120 includes a chemical passivation layer (not shown in FIG. 1) and a field passivation layer (not shown in FIG. 1). The chemical passivation layer is disposed on the front surface of the silicon substrate 110. The field passivation layer is disposed on a surface of the chemical passivation layer away from the silicon substrate 110. Correspondingly, the anti-reflection layer 130 is disposed on the surface of the field passivation layer away from the silicon substrate 110. The chemical passivation layer can saturate the defects on the front surface of the silicon substrate 110 and reduce the defect concentration, thereby reducing the recombination centers in the forbidden band, and further improving the efficiency of the solar cell. The field passivation layer can form an electrostatic field at the interface through charge accumulation, thereby reducing the minority carrier concentration and further improving the efficiency of the solar cell.

As shown in FIG. 1, in some embodiments, the front surface of the silicon substrate 110, the first passivation layer 120, and the anti-reflection layer 130 located on the front surface have a pyramidal texture. When the solar cell is operating, sunlight is incident on the silicon substrate 110 from the front surface of the silicon substrate 110. The pyramidal texture can trap light and reduce reflection, thereby improving the utilization rate of light by the solar cell.

The silicon substrate 110 of the present disclosure is of a first doping type. The first doping type can be p-type, that is, the silicon substrate 110 is a p-type silicon substrate; it can also be n-type, that is, the silicon substrate 110 is an n-type silicon substrate. This disclosure does not limit the specific doping elements used to form the p-type and the n-type.

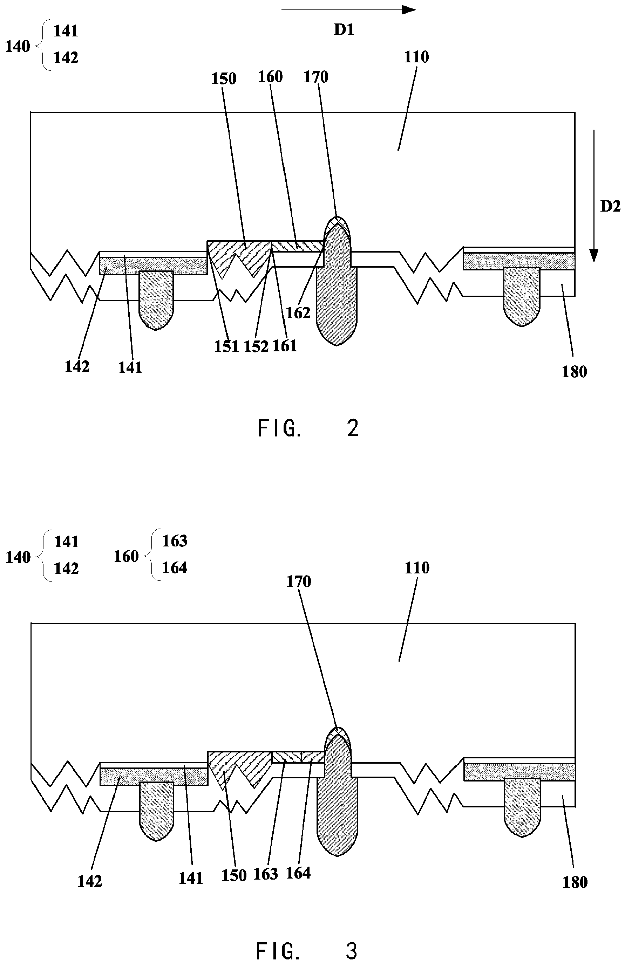

Continuing to refer to FIG. 1, the first emitter 140, the first isolation region 150, the second isolation region 160, and the second emitter 170 are successively disposed on the back surface of the silicon substrate 110 in the first direction D1, as shown in FIG. 1, the first direction D1 intersects the thickness direction D2. Refer to FIG. 2, which is a partially enlarged schematic diagram of the rectangular dotted box portion of the back-contact solar cell in FIG. 1. The first isolation region 150 has a first side 151 and a second side 152 opposite to each other in the first direction D1. The second isolation region 160 has a third side 161 and a fourth side 162 opposite to each other in the first direction D1. The first side 151 connects to the first emitter 140, the second side 152 connects to the third side 161, and the fourth side 162 connects to the second emitter 170. It should be noted that the positional relationship among the first emitter 140, the first isolation region 150, the second isolation region 160, and the second emitter 170 is not limited to the embodiment in FIG. 1. For example, in some other embodiments, the first isolation region 150 and the second isolation region 160 are disposed between the first emitter 140 and the second emitter 170 and do not connect to each other, or the first isolation region 150 and the second isolation region 160 connect to each other, but the first isolation region 150 does not connect to the first emitter 140, and the second isolation region 160 does not connect to the second emitter 170. The first emitter 140 is of a second doping type. The first isolation region 150 and the second emitter 170 are of the first doping type. The second isolation region 160 is of the second doping type or the first doping type, or a first portion of the second isolation region 160 is of the first doping type and a second portion of the second isolation region 160 is of the second doping type. The doping type of the second isolation region 160 will be described in detail later and will not be illustrated here. The polarity of the second doping type is opposite to that of the first doping type, that is, when the first doping type is p-type, the second doping type is n-type, and when the first doping type is n-type, the second doping type is p-type.

FIG. 2 is a partially enlarged schematic diagram of the rectangular dotted frame portion of the back-contact solar cell in FIG. 1. Referring to FIG. 2, the first emitter 140 includes a tunnel oxide layer 141 and a polysilicon layer 142. The tunnel oxide layer 141 is disposed on the back surface of the silicon substrate 110, and the polysilicon layer 142 is disposed on a surface of the tunnel oxide layer 141 away from the silicon substrate 110. The polysilicon layer 142 is of the second doping type. In other words, the doping type of the polysilicon layer 142 has an opposite polarity to that of the silicon substrate 110.

In some embodiments, a thickness of the tunnel oxide layer 141 is 1-20 nm, and a thickness of the polysilicon layer 142 is 20-1000 nm. The tunnel oxide layer 141 may be silicon dioxide. The tunnel oxide layer 141 and the polysilicon layer 142 have the effect of selective collection of carriers. That is, the majority carriers can easily pass through the tunnel oxide layer 141, while the minority carriers have difficulty of passing through the tunnel oxide layer 141.

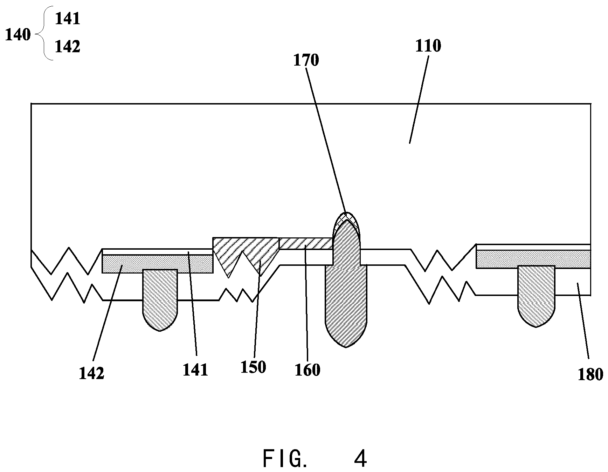

The doping types of the first isolation region and the second isolation region of the present disclosure will be described next. Referring to FIGS. 2, 3, and 4, unless otherwise specified, the same reference signs in FIGS. 2, 3 and 4 have the same meaning. In FIG. 2, the first isolation region 150 is of the first doping type, and the second isolation region 160 is of the second doping type. Referring to FIG. 3, the first isolation region 150 and the second isolation region 160 are adjacent in the first direction D1; and different from FIG. 2: the first portion of the second isolation region 160 is of the first doping type, the first portion is indicated as 163 in FIG. 3, and the second portion of the second isolation region 160 is of the second doping type, the second portion is indicated as 164 in FIG. 3. It should be noted that the relative positional relationship between the first portion 163 and the second portion 164 is not limited to that shown in FIG. 3. For example, the second portion 164 may be located on the left side of the first portion 163. A ratio (volume ratio or mass ratio) of the first portion 163 to the second isolation region 160 and a ratio (volume ratio or mass ratio) of the second portion 164 to the second isolation region 160 are not limited to FIG. 3. In other words, assuming that the ratio of the first portion 163 to the second isolation region 160 is x, x can be any value greater than 0% and less than 100%, then the ratio of the second portion 164 is 100%-x. It should be noted that due to objective reasons such as the manufacturing process, the second isolation region 160 may have a portion that is neither the first doping type nor the second doping type; in this case, the ratio of the second portion 164 is less than 100 %-x. Referring to FIG. 4, what is different from FIG. 2 and FIG. 3 is that the second isolation region 160 in FIG. 4 is of the first doping type. In order to more clearly understand the first isolation region and the second isolation region in the back-contact solar cell of the present disclosure, the positions and composition of the first isolation region and the second isolation region are described through the process of forming the first isolation region and the second isolation region.

Referring to FIG. 2, the tunnel oxide layer 141 and the polysilicon layer 142 cover part of the back surface of the silicon substrate 110. The process of forming the tunnel oxide layer 141 and the polysilicon layer 142 that partially covers the back surface of the silicon substrate 110 is as follows. Forming the tunnel oxide layer 141 covering the entire back surface of the silicon substrate 110, then forming the polysilicon layer 142 covering the entire tunnel oxide layer 141, next removing the unnecessary tunnel oxide layer 141 and polysilicon layer 142 through an etching process and retaining the tunnel oxide layer 141 and the polysilicon layer 142 that corresponds to the first emitter 140. Referring to FIG. 1 and 2 together, when the polysilicon layer 142 in the second isolation region 160 is retained, in this case, the second isolation region 160 is of the second doping type, which is the situation shown in FIG. 2. Referring to FIG. 3, when a portion of the polysilicon layer 142 in the second isolation region 160 is retained, in this case, the first portion 163 in the second isolation region 160 is of the first doping type, and the second portion 164 in the second isolation region 160 is of the second doping type, which is the situation shown in FIG. 3. Referring to FIG. 4, when all the polysilicon layer 142 in the second isolation region 160 is removed, in this case, all the second isolation region 160 is of the first doping type, that is, the situation shown in FIG. 4. It should be noted that the above embodiment is only a case of forming the first isolation region and the second isolation region, and the method of forming the first isolation region and the second isolation region in this disclosure is not limited to the above embodiment.

In one embodiment, as shown in FIG. 2, the first isolation region 150 has a pyramidal texture. In this embodiment, the pyramidal texture of the first isolation region 150 and the pyramidal texture on the front surface of the silicon substrate 110 are formed in the same texturing process step, and the step of forming the first isolation region and the second isolation region can be combined with the texturing process step to simplify the process. In addition, as shown in FIG. 2, pyramidal texture of the first isolation region 150 has protrusions of different sizes, which is caused by the properties of the texturing process itself. In some other embodiments, the surface of the second isolation region 160 away from the silicon substrate 110 in the thickness direction D2 has a flat topography. This flat topography can be obtained by chemical mechanical polishing (CMP).

Returning to FIG. 1, in one embodiment, the solar cell 100 further includes a second passivation layer 180. As shown in FIG. 2, the second passivation layer 180 is disposed on a surface of the first emitter 140, the first isolation region 150 and the second isolation region 160 away from the silicon substrate 110. In some embodiments, the second passivation layer is one or more of silicon nitride, aluminum oxide, titanium oxide, silicon oxide, and silicon oxynitride. In FIG. 1, the second passivation layer 180 formed on the surface of the first isolation region 150 away from the silicon substrate 110 has a pyramid texture. This is because the first isolation region 150 has the pyramidal texture, which results in the second passivation layer 180 deposited on the first isolation region 150 also having the pyramidal texture.

As shown in FIGs. 1 and 2, one side of the second isolation region 160 in the first direction D1 is adjacent to the first isolation region 150, and the other side is adjacent to the second emitter 170. The second emitter 170 is in contact with the silicon substrate 110 and has the same doping type as the silicon substrate 110, that is, both are the first doping type. In some embodiments, the doping concentration of the second emitter 170 is greater than the doping concentration of the silicon substrate 110.

Based on the foregoing description of the first emitter, the first isolation region, the second isolation region, and the second emitter, the functions of the first isolation region and the second isolation region will be described next.

Referring to FIG. 2, as mentioned above, in order to form the first emitter 140, a polysilicon layer 142 is formed on the back surface of the silicon substrate 110.

If the polysilicon layer 142 formed on the back surface of the silicon substrate 110 is not removed, the polysilicon layer 142 located between the first emitter 140 and the second emitter 170 connects the first emitter 140 and the second emitter 170. As a result, the reverse leakage of the solar cell exceeds the standard, which in turn causes the solar cell module composed of the solar cell to fail the hot spot test.

Returning to FIG. 1, in one embodiment, the solar cell 100 further includes a first electrode 190 and a second electrode 210. One end of the first electrode 190 penetrates the second passivation layer 180 and contacts the polysilicon layer 142 in the first emitter 140, and one end of the second electrode 210 penetrates the second passivation layer 180 and contacts the second emitter 170. The other end of the first electrode 190 and the other end of the second electrode 210 may be connected to external devices.

The solar cell in the above embodiment of the present disclosure solves the problem of excessive reverse leakage of the solar cell and failure to pass the hot spot test by arranging the first isolation region and the second isolation region between the first emitter and the second emitter.

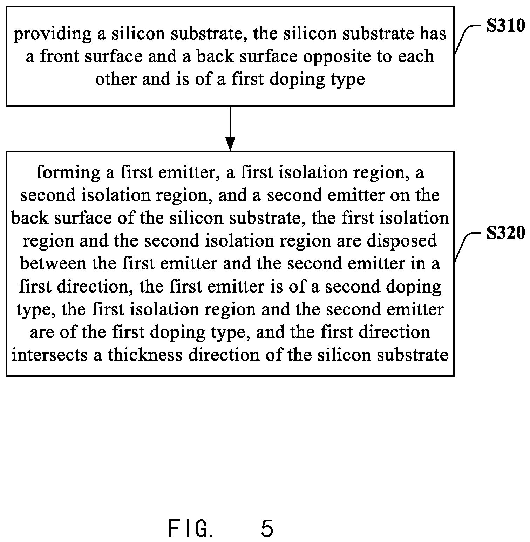

In another aspect, this disclosure also proposes a method for producing a back-contact solar cell. Refer to FIG. 5 for an exemplary flow chart of a method for producing a back-contact solar cell according to an embodiment of the present disclosure. The method in this embodiment includes the following steps.
Step S310: providing a silicon substrate, the silicon substrate has a front surface and a back surface opposite to each other and is of a first doping type,
Step S320: forming a first emitter, a first isolation region, a second isolation region, and a second emitter on the back surface of the silicon substrate, the first isolation region and the second isolation region are disposed between the first emitter and the second emitter in a first direction, the first emitter is of a second doping type, the first isolation region and the second emitter are of the first doping type, and the first direction intersects a thickness direction of the silicon substrate.

The above-mentioned steps S310 and S320 are described in detail below with reference to FIG. 1 and FIG. 5.

In step S310, it provides a silicon substrate 110 whose doping type is the first doping type. Preferably, the silicon substrate 110 is single-crystal silicon. The silicon substrate 110 has a front surface and a back surface opposite to each other in the thickness direction D2.

In step S320, the first emitter 140, the first isolation region 150, the second isolation region 160, and the second emitter 170 are formed on the back surface of the silicon substrate 110. The first isolation region 150 and the second isolation region 160 are formed between the first emitter 140 and the second emitter 170 in the first direction D 1, wherein the first direction D1 intersects the thickness direction D2 of the silicon substrate.

As shown in FIG. 2, in one embodiment, the first side 151 of the first isolation region 150 connects with the first emitter 140, and the second side 152 of the first isolation region 150 connects with the third side 161 of the second isolation region 160. The fourth side 162 of the second isolation region 160 connects the second emitter 170.

Further, the first emitter 140 is of the second doping type. The first isolation region 150 and the second emitter 170 are of the first doping type. The second isolation region 160 is of the second doping type or the first doping type, or the first portion of the second isolation region 160 is of the first doping type, and the second portion of the second isolation region 160 is of the second doping type.

In one embodiment, the first emitter 140 includes a tunnel oxide layer 141 and a polysilicon layer 142. As shown in FIG. 2, the tunnel oxide layer 141 is disposed on the back surface of the silicon substrate 110, and the polysilicon layer 142 is disposed on the surface of the tunnel oxide layer 141 away from the silicon substrate 110. The polysilicon layer 142 is of the second doping type, a thickness of the tunnel oxide layer 141 is 1-20 nm, and a thickness of the polysilicon layer is 20-1000 nm. The tunnel oxide layer 141 can be silicon dioxide. The tunnel oxide layer 141 and the polysilicon layer 142 can achieve selective collection of carriers. That is, the majority carriers can easily pass through the tunnel oxide layer 141, while the minority carriers have difficulty passing through the tunnel oxide layer 141.

In one embodiment, as shown in FIG. 1, a first passivation layer 120 and an anti-reflection layer 130 are successively formed on the front surface of the silicon substrate 110 in the thickness direction D2. The method of forming the first passivation layer 120 and the anti-reflection layer 130 includes chemical vapor deposition (CVD) and/or physical vapor deposition (PVD). In some embodiments, the first passivation layer 120 includes a chemical passivation layer and a field passivation layer, when forming the first passivation layer 120, the chemical passivation layer is first formed on the front surface of the silicon substrate 110, and then the field passivation layer is formed on the surface of the chemical passivation layer away from the silicon substrate 110.

In one embodiment, the first isolation region 150 has a pyramidal texture. The method of forming the pyramidal texture includes etching the surface of the first isolation region 150 away from the silicon substrate 110 using an alkali solution. In one embodiment, the pyramidal texture of the first isolation region 150 and the pyramidal texture on the front surface of the silicon substrate 110 are formed in the same texturing process step, thereby simplifying the process. In some other embodiments, the surface of the second isolation region 160 away from the silicon substrate 110 in the thickness direction D2 has a flat topography. The flat topography can be obtained by chemical mechanical polishing (CMP).

For other details about the method for producing the back-contact solar cell of the present disclosure, please refer to the previous description of the back-contact solar cell, which will not be elaborated here. The method of the present disclosure solves the problem of excessive reverse leakage of the solar cell and failure to pass the hot spot test by arranging the first isolation region and the second isolation region between the first emitter and the second emitter.

The basic concepts have been described above. Obviously, for those skilled in the art, the above disclosure disclosures are only embodiments and do not constitute limitations to the present disclosure. Although not explicitly stated herein, those skilled in the art may make various modifications, improvements, and corrections to this disclosure. Such modifications, improvements, and corrections are suggested in this disclosure, so such modifications, improvements, and corrections still fall within the spirit and scope of the exemplary embodiments of this disclosure.

And, this disclosure uses specific words to describe the embodiments of the disclosure. For example, "one embodiment", "an embodiment", and/or "some embodiments" means a certain feature, structure, or characteristic related to at least one embodiment of the present disclosure. Therefore, it should be emphasized and noted that "one embodiment" or "an embodiment" or "an alternative embodiment" mentioned twice or more at different places in this specification does not necessarily refer to the same embodiment. In addition, certain features, structures or characteristics in one or more embodiments of the present disclosure may be appropriately combined.

In some embodiments, numbers are used to describe the quantities of components and properties. It should be understood that such numbers used to describe the embodiments are modified by the modifiers "about", "approximately" or "substantially" in some embodiments. Grooming. Unless otherwise stated, "about," "approximately," or "substantially" means that the stated number is allowed to vary by ± 20%. Accordingly, in some embodiments, the numerical parameters used in the specification and claims are approximations that may vary depending on the desired features of the individual embodiment. In some embodiments, numerical parameters should account for the specified number of significant digits and use general digit preservation methods. Although the numerical fields and parameters used to confirm the breadth of the ranges in some embodiments of the present disclosure are approximations, in specific embodiments, such numerical values are set as accurately as feasible.

## Claims

1. A back-contact solar cell, **characterized by** comprising:
a silicon substrate having a front surface and a back surface opposite to each other, and the silicon substrate is of a first doping type; and
a first emitter, a first isolation region, a second isolation region, and a second emitter disposed on the back surface of the silicon substrate, wherein the first isolation region and the second isolation region are disposed between the first emitter and the second emitter in a first direction, the first emitter is of a second doping type, the first isolation region and the second emitter are of the first doping type, and the first direction intersects a thickness direction of the silicon substrate.

2. The solar cell of claim 1, **characterized in that** the first emitter, the first isolation region, the second isolation region, and the second emitter are successively disposed on the back surface of the silicon substrate in the first direction.

3. The solar cell of claim 2, **characterized in that** the first isolation region has a first side and a second side opposite to each other in the first direction, and the second isolation region has a third side and a fourth side opposite to each other in the first direction, the first side connects to the first emitter, the second side connects to the third side, and the fourth side connects to the second emitter.

4. The solar cell of claim 1, **characterized in that**, optionally:
- the second isolation region is of the second doping type or the first doping type; or
- a first portion of the second isolation region is of the first doping type, and a second portion of the second isolation region is of the second doping type.

5. The solar cell of claim 1, **characterized in that** the first emitter includes a tunnel oxide layer and a polysilicon layer, the tunnel oxide layer is disposed on the back surface of the silicon substrate, and the polysilicon layer is disposed on a surface of the tunnel oxide layer away from the silicon substrate, and the polysilicon layer is of the second doping type.

6. The solar cell of claim 1, **characterized in that** the first isolation region has a pyramidal texture, and/or a surface of the second isolation region away from the silicon substrate in the thickness direction has a flat topography.

7. The solar cell of claim 1, **characterized by** further comprising a first passivation layer and an anti-reflection layer, wherein the first passivation layer and the anti-reflection layer are successively disposed on the front surface of the silicon substrate in the thickness direction.

8. The solar cell of claim 7, **characterized in that** the first passivation layer includes a chemical passivation layer and a field passivation layer, wherein the chemical passivation layer is disposed on the front surface of the silicon substrate, the field passivation layer is disposed on a surface of the chemical passivation layer away from the silicon substrate.

9. A method for producing a back-contact solar cell, **characterized by** comprising:
providing a silicon substrate having a front and a back surface opposite to each other and being of a first doping type; and
forming a first emitter, a first isolation region, a second isolation region, and a second emitter on the back surface of the silicon substrate, wherein the first isolation region and the second isolation region are disposed between the first emitter and the second emitter in a first direction, the first emitter is of a second doping type, the first isolation region and the second emitter are of the first doping type, and the first direction intersects a thickness direction of the silicon substrate.

10. The method according to claim 9, **characterized in that** the first emitter, the first isolation region, the second isolation region, and the second emitter are successively formed on the back surface of the silicon substrate.

11. The method of claim 10, **characterized in that** the first isolation region has a first side and a second side opposite to each other in the first direction, and the second isolation region has a third side and a fourth side opposite to each other in the first direction, the first side connects to the first emitter, the second side connects to the third side, and the fourth side connects to the second emitter.

12. The method of claim 9, **characterized in that** the first emitter includes a tunnel oxide layer and a polysilicon layer, the tunnel oxide layer is disposed on the back surface of the silicon substrate, and the polysilicon layer is disposed on a surface of the tunnel oxide layer away from the silicon substrate, wherein the polysilicon layer is of the second doping type.

13. The method of claim 9, **characterized in that** the first isolation region has a pyramidal texture, and/or a surface of the second isolation region away from the silicon substrate in the thickness direction has a flat topography, wherein a manner of forming the pyramid texture includes using an alkali solution to etch a surface of the first isolation region away from the silicon substrate.

14. The method of claim 9, **characterized in that**, optionally:
- the second isolation region is of the second doping type or the first doping type; or
- a first portion of the second isolation region is of the first doping type, and a second portion of the second isolation region is of the second doping type.

15. The method of claim 9, **characterized by** further comprising successively forming a first passivation layer and an anti-reflection layer on the front surface of the silicon substrate in the thickness direction.
